## Europäisches Patentamt

## European Patent Office

## Office européen des brevets

(11) Publication number: **0 164 138**
**B1**

(12) # EUROPEAN PATENT SPECIFICATION

(45) Date of publication of patent specification: **16.08.89**

(51) Int. Cl.⁴: **G 06 F 13/22, G 06 F 13/40**

(21) Application number: **85200462.1**

(22) Date of filing: **11.02.81**

(60) Publication number of the earlier application in accordance with Art. 76 EPC: **0 035 334**

(54) Data processing system with a plurality of input/output buses.

(30) Priority: **11.02.80 US 120272**
**11.02.80 US 120271**
**11.02.80 US 120291**
**11.02.80 US 120292**

(43) Date of publication of application:
**11.12.85 Bulletin 85/50**

(45) Publication of the grant of the patent:
**16.08.89 Bulletin 89/33**

(84) Designated Contracting States:
**CH DE FR GB IT LI NL SE**

(56) References cited:
**US-A-3 221 307**
**US-A-4 000 485**
**IEEE TRANSACTIONS ON NUCLEAR SCIENCE, vol. NS-26, no. 4, August 1979, pages 4525-4530, New York, US; R.W.DOWNING: "Fastbus - Details of addressing and bus mastership"**
**IEEE TRANSACTIONS ON NUCLEAR SCIENCE, vol. NS-26, no. 1, February 1979, pages 679-685, New York, US; R.S.LARSEN: "Status of the interlaboratory development of a high-speed standard data bus - fastbus"**

(73) Proprietor: **DATA GENERAL CORPORATION**
**Route 9**
**Westboro Massachusetts 01581 (US)**

(72) Inventor: **Bernstein, David H.**
**252 Delphi Circle**
**Los Altos California 94022 (US)**
Inventor: **Carberry, Richard A.**
**23965 Glenwood Drive**
**Los Gatos California 95030 (US)**
Inventor: **Druke, Michael B.**
**32 Longmeadow Road**
**Chelmsford Massachusetts 01824 (US)**
Inventor: **Gusowski, Ronald I.**
**5 Baxter Street**
**Westboro Massachusetts 01581 (US)**
Inventor: **Buckley, Edward M.**
**68 Dutcher Street**
**Hopedale Massachusetts 01747 (US)**
Inventor: **March, Roger W.**
**3422 Georgetown Place**
**Santa Clara California 95051 (US)**

(74) Representative: **Pears, David Ashley et al**
**REDDIE & GROSE 16 Theobalds Road**
**London WC1X 8PL (GB)**

Courier Press, Leamington Spa, England.

# EP 0 164 138 B1

(56) References cited:
**IEEE COMPUTER SOCIETY INTERNATIONAL
CONFERENCE, COMPCON 75, 25th-27th
February 1975, San Francisco, pages 27-30,
New York, US; A.BAUM et al.: "Hardware
considerations in a microcomputer
multiprocessing system"**

# EP 0 164 138 B1

**Description**

The present invention relates to a data processing system as set forth in the introductory part of Claim 1.

Such a system is known from US—A—3 221 307 in which, however, the polling of the devices on a bus is a hardware determined polling of the devices in fixed sequence to enable them to inform the computer of their addresses or device code signals, as stored in the devices themselves. Each bus has to be pulled in this way to set up the address to the pertaining to that device.

Another system known from "Hardware considerations in a microcomputer multiprocessing system" Baum and Senzig, IEEE Computer Society International Conference Comp Con 25/27 February 1975, pages 27 to 30 uses "bus links" i.e. interfaces, to interface a system bus to input/output buses. Each bus link has to be set up with its own table of device addresses which is can service.

The object of the present invention is to provide an improved system which automates the determination of which input/output bus is to be employed, particularly in the specific context of utilising two buses to cater for different devices having different bus characteristics. A further object is to provide a system which can adapt continuously to the changing situation of which devices are active on which bus.

The system according to the present invention is characterised in the manner set forth in Claim 1.

The invention will now be described in more detail, by way of example, with reference to the accompanying drawings, in which:

Fig. 1 is a broad block diagram of an overall system in accordance with the invention;

Figs. 2 and 3 are block diagrams of the system I/O interface unit of Fig. 1;

Fig. 4 is a more specific block diagram of a portion of the system I/O interface unit of Figs. 2 and 3;

Fig. 5 is a more specific logic diagram of the master control finite state machine and control logic of Figs. 2 and 3;

Fig. 6 is a more specific logic diagram of the microNOVA finite state machine and control logic of Figs. 2 and 3; and

Figs. 7 and 8 show more specific logic diagrams of the microNOVA polling logic of Figs. 2 and 4.

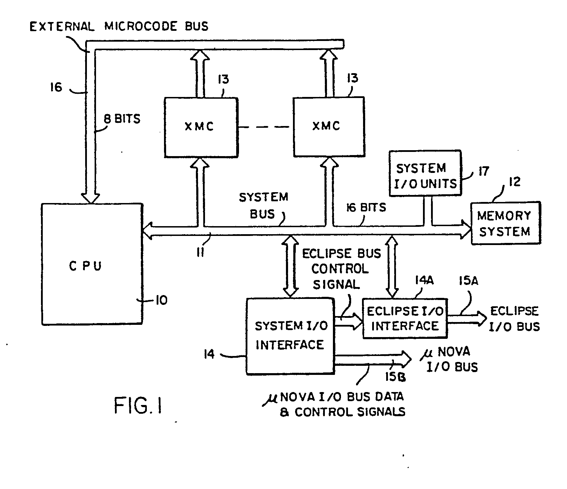

An overall system using the techniques of the invention is shown in Fig. 1 wherein microprocessor chip 10 (identified as a central processor unit or CPU in the Figure) is interconnected via an appropriate system bus 11 with a memory system 12, one or more system I/O units 17, one or more external microcontroller chips 13 (identified as "XMC" chips) and a system input/output interface unit 14 (identified as the system I/O interface) and a further interface unit 14A (identified as ECLIPSE® I/O interface) which latter units interface with appropriate buses 15B and 15A for external input/output devices. For example, in a particular embodiment the system is designed to operate with peripheral (I/O) units of the microNOVA type as used with microNOVA® computer systems as made and sold by Data General Corporation of Westboro, Massachusetts and with peripheral (IO) units of the ECLIPSE® type as used with ECLIPSE® computer systems made by Data General Corporation.

Information transfer (i.e. addresses, data, instructions, etc) to and from the CPU from system components other than the CPU, such as one or more memory units and one or more input/output (I/O) devices, takes place on the 16-bit system bus 11 either directly or via interface units 14 and 17. An effective system bus protocol must be utilised in order to provide for the correct transfer of such information. This aspect of the system is described in application No. 83200686.0 published as EPO 094 140.

The system CPU is arranged to be capable of communicating with I/O devices on a plurality of different buses. Thus, the CPU may communicate with I/O devices directly on the system bus 11, with I/O devices on bus 15A designated in this embodiment, as the ECLIPSE® I/O bus for ECLIPSE® I/O devices, or on bus 15B designated in this embodiment as the microNOVA® bus for microNOVA® devices. In accordance with the system described herein, data can be transferred directly to and from the system I/O devices via the system bus 11, as described in more detail below, while data for ECLIPSE® I/O devices are transferred to and from such devices via ECLIPSE® bus 15A through a separate ECLIPSE® I/O interface unit 14A, the transfer thereof being controlled by control signals from the system I/O interface unit 14. Further, data for the microNOVA® I/O devices are transferred to and from such devices on the microNOVA® bus 15B through the system I/O interface unit.

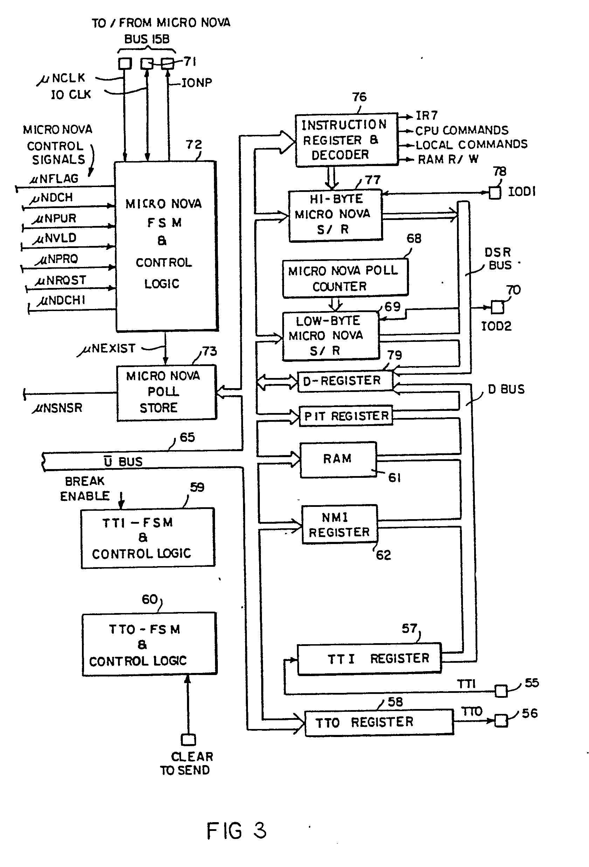

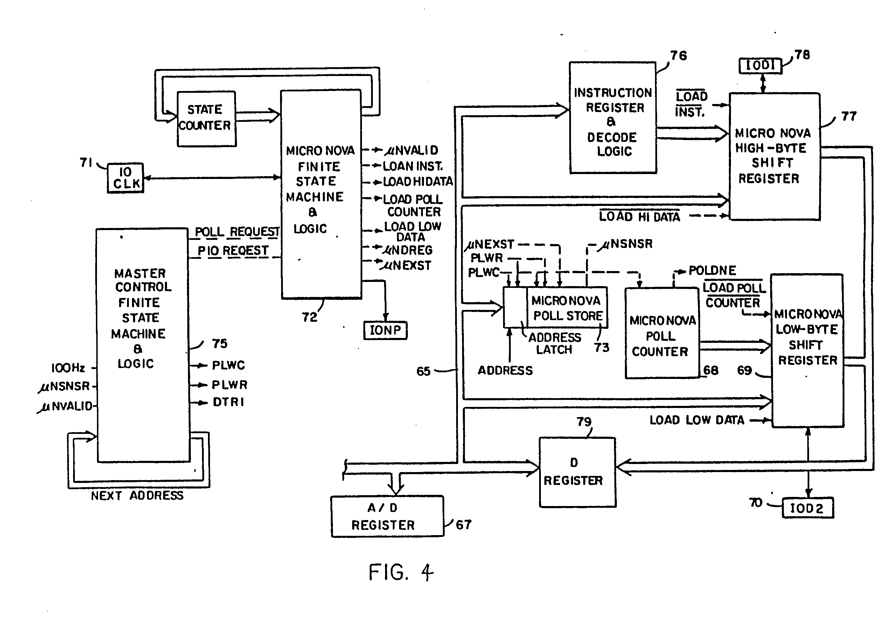

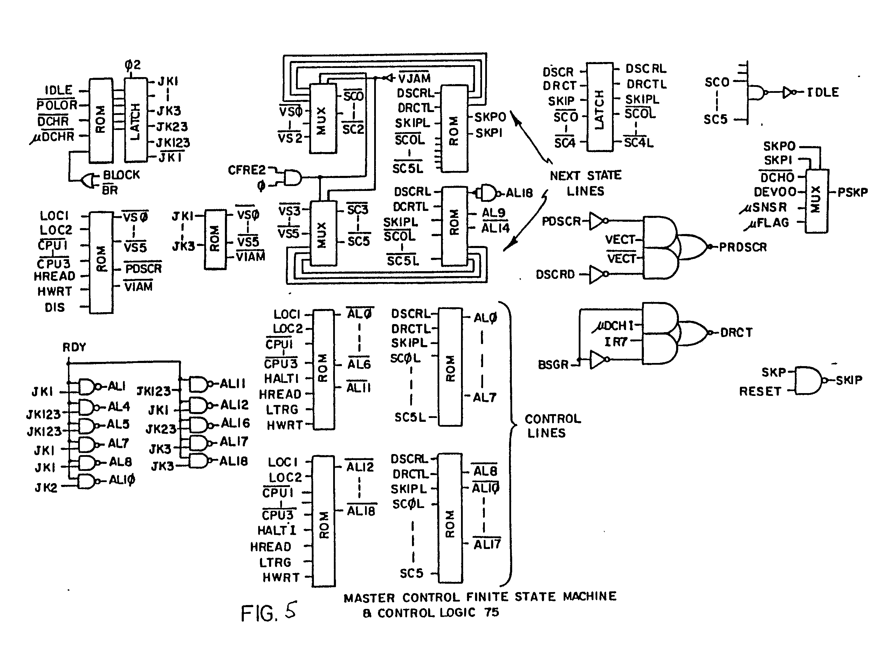

A more detailed block diagram of the system I/O interface unit 14 is shown in Figs. 3 and 4. A further, even more detailed, block digram of the microNOVA® bus control logic for address/data transfers and for microNOVA® polling operation (as discussed in more detail below) is shown in Fig. 5B. As can be seen therein, the system I/O interface unit comprises a plurality of local, or internal, devices and various control logic circuits, shown as block 50, the devices being of the type which are already known and used with respect to previously available systems. For example, the internal devices of the system I/O interface unit 14 may include devices of the type utilized in the Data General Corporation ECLIPSE® computer systems, as shown and discussed with reference to the following publications.

ECLIPSE® M/600 Principles of Operation No. 014—000092.

ECLIPSE® S/250 Programmer's Reference Manual No. 014—000611.

Interface Designer's Reference NOVA® and ECLIPSE® Line Computers No. 015—000031.

microNOVA® Integrated Circuits Data Manual No. 014—000074.

The above publications are representative of publications available from Data General Corporation,

3

Westboro, Massachusetts concerning NOVA®, ECLIPSE®, and microNOVA® systems made and sold by Data General Corporation. Such publications contain information useful as background information in understanding not only the aforementioned internal devices but also various other aspects of the system being described herein.

Thus, such devices may include a "programmable interval timer" (PIT) unit which provides a programmable timing signal which produces clock signals at a counter clock rate at one of four selectable frequencies, for example. In a particular embodiment, for example, the programmable interval time can be arranged to produce counter clock intervals at 1 MHz, 100 KHz, 10 KHz or 1 KHz from a constant input clock siganl of 1 MHz through well-known freqwuency divider techniques. In the system I/O unit, such timer responds to a pseudo-constant 1 MHz signal which is derived from a frequency synthesizer unit 51.

The local devices may also include, for example, a "real time clock" (RTC) unit which generates timing pulses that are independent of the system clock rate. The real time clock can interrupt at any one of four selectable frequencies, for example, at the AC line frequency, or at 10 Hz, 100 Hz or 1000 Hz the latter three clocks all derived from the pseudo-constant 1 MHz signal through well-known frequency divider techniques.

The internal devices may also include a power monitor unit which detects any transition of a power monitor pulse which indicates that AC power has failed or that AC power has returned after a momentary power failure, or that a start up power condition exists.

The system I/O interface unit also includes appropriate input and output interface logic via which serial data can be asynchronously supplied (as from a teletype unit, for example), such inputs and outputs being supplied via TTI pin 55 and TTO pin 56, respectively, and from input and output registers 57 and 58, respectively, in a controlled manner in accordance with standard practice utilizing suitable finite state machine (FSM) and control logic 59 and 60. As in prior art devices utilizing asynchronous, serial data terminal inputs and outputs, the terminal unit may operate at selectable baud rates, the available baud rates being selected from a large number of such rates ranging in a particular case from 50 baud to 38400 baud, for example. For such purpose in this system the baud rate signals are derived from a pseudo-constant 614,400 Hz master baud rate signal, also obtained from the frequency synthesizer unit 51. The selected baud rates can be obtained therefrom though suitable baud rate selection logic in accordance with well-known techniques of prior art systems which utilize such asyncronous, serial data input and output operation.

The internal units and the terminal logic discussed above do not form a part of the inventive aspects of the system I/O interface unit 14 and need not be described in further detail.

For convenience, an appropriate random access memory (RAM) storage unit 61 may also be present on the system I/O interface unit for providing temporary storage space which may be used, for example, when performing console operations. Such storage unit is of a well-known RAM type which can be formed to provide storage space of an appropriate size for the desired console use. For example, a particular embodiment may be capable of storing a selected number of 16-bit words for such purpose. As such, the RAM unit 61 does not form a part of the inventive aspects of the system I/O interface unit 14 and need not be discussed in more detail. Further a non-maskable interrupt (NMI) register 62 for use as described in the aforesaid ECLIPSE® and microNOVA® documents may also be part of the system I/O interface unit 14 but does not form a part of the inventive aspects thereof and need not be described in further detail.

Addresses and data are supplied to and from the system bus 11 at the system I/O interface unit 14 in the form of 16-bit words ($\overline{MB\emptyset-15}$) supplied at the physical address/data (PADS) pins 63. Suitable driver and multiplexer circuits 64 are utilized for such purpose, the address and data words which are being transferred to or from the system bus being supplied to internal $\overline{U}$ bus 65 for use in the system I/O interface unit 14 either directly via an internal bus 66 or indirectly via temporary address/data register 67 which may be used for temporary storage thereof before such addresses and data are supplied to the system I/O interface unit or to the system bus depending on the direction of transfer thereof.

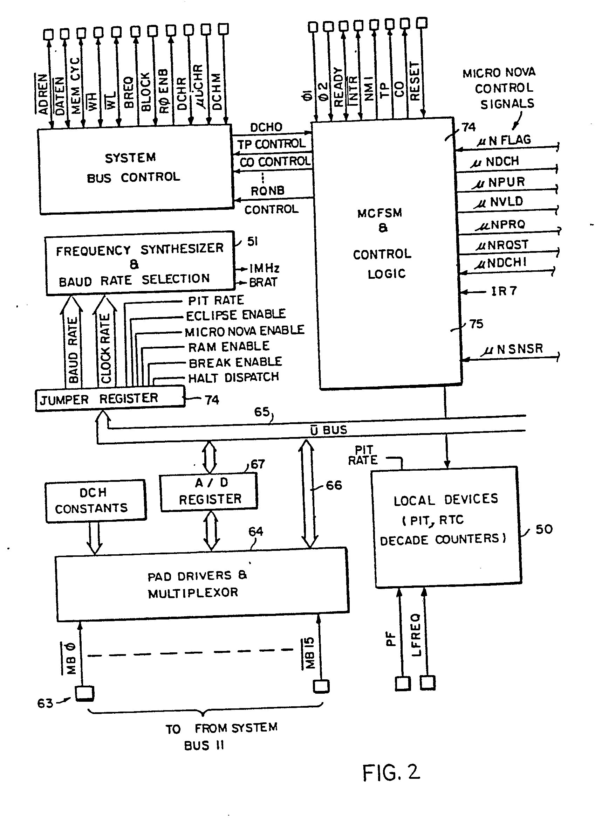

The I/O buses which must be used to transfer addresses and data between the CPU and the I/O devices with which the CPU may desire communication differ depending on which type of I/O devices are involved (e.g., ECLIPSE® devices which communicate via ECLIPSE® bus 15A, microNOVA® devices which communicate via microNOVA® bus 15B and all other devices which communicate via system bus 11). The system I/O interface unit 14 must decide which I/O device is involved and, hence, which I/O bus is to be used for the transfer of such data so that the interface unit control can control such transfer to and form the CPU. In accordance with the system of the invention disclosed in Figs. 2 and 3, and the more detailed block diagram of Fig. 4. The system I/O interface unit 14 contains logic circuitry for identifying all of the devices which are on a selected one of the two buses which it controls, namely, buses 15A and 15B. Such identification can be achieved by appropriately "polling" the selected one of such buses and storing suitable information as to which devices are on the selected bus.

In accordance with a specific embodiment of the invention which utilizes either a microNOVA® I/O bus 15B or an ECLIPSE® I/O bus 15A, the system I/O interface unit is arranged to "poll" the microNOVA® I/O bus 15B to determine which devices are on such bus. A suitable microNOVA® poll counter 68 supplies each of the expected device code words which identify the various devices which are likely to be used with the system, which device code words, for example, are 6-bit device codes supplied to the microNOVA® I/O bus 15B via "low-byte" (a byte is 8 bits) shift register 69 from poll counter 68 to the ouptut microNOVA® bus pin 70 identified as IOD2 in Fig. 3. The 6-bit device codes are supplied in parallel to shift register (S/R) 69 during the polling process and are in turn supplied serially to the microNOVA® bus from shift register 69.

When microNOVA® I/O devices, which communicate with the CPU on the mciroNOVA® bus 15B, are interrogated with a device code signal for identification thereof, such devices supply a return identifiable I/O clock (IOCLK) signal at pin 71 to microNOVA® finite state machine and control logic 72 if a device matching a particular device code is present on the microNOVA® bus. Such operation is in contrast with devices on the ECLIPSE® bus 15A for which no such identifiable I/O clock signal would be present if such devices were interrogated with the device codes. Because of such contrasting operations microNOVA® devices can be "polled" to determine their presence on microNOVA® bus 15B and a record of their presence kept in the system I/O interface unit 14.

Thus, receipt of an IOCLK signal at pin 71 from a particular I/O device on the microNOVA® bus is supplied to control logic in the microNOVA® finite state machine and control logic unit 72. Such logic generates a microNOVA® exist signal (sometimes referred to as µNEXST) for supply to a microNOVA® poll register 73 to indicate that an I/O device having such device code is present on the microNOVA® bus.

The microNOVA® poll store register 73, for example, is a 64-bit register, each bit corresponding to a particular device code (in particular embodiment there being up to 64 possible microNOVA® devices which can be present on the miocroNOVA® bus). If a 6-bit device code representing a specified device which has been interrogated is provided at the input thereto from microNOVA® poll counter 68, the particular bit associated therewith will be placed in a state which indicates the presence or absence of such device on the microNOVA® bus, depending on whether a µNEXST signal is so generated. Accordingly, when all of the device codes have been polled, the microNOVA® poll register 73 contains information as to the presence of all devices which are on the microNOVA® I/O bus 15B.

Polling of the microNOVA® bus is first performed at "start-up", the complete set of 64 possible devices in a particular embodiment, for example, being polled during one overall polling time interval before the overall system is put into operation. If, for example, the polling of each device takes IO microseconds, or less, the complete poll can be accomplished in 600—700 microseconds. Once the system is in operation, updating of the poll store can be accomplished as devices previously indicated as not being present are turned on and devices previously indicated as present are turned off. Such updated polling can be accomplished at a 100 Hz rate, a single device being polled each .01 seconds (a completed update polling of all devices occurs every 0.6—0.7 seconds, for example).

In some cases a device will be turned on and could, therefore, be present on the microNOVA® bus but the poll store may not indicate its presence (the updating for such device may not yet have occured since the device came on line after the last update poll. If, under such condition, the device requests an interrupt operation, the interrupt request itself indicates the presence of the device and the microNOVA® poll register is automatically updated by appropriate gating in the microNOVA® finite state machine logic which provides a µNEXST signal to the poll register.

All devices which are not identified as being on the microNOVA® I/O bus, but which are in communication with the system, will by the process of elimination be either on the ECLIPSE® I/O bus 15A or on the system bus 11. As will be noted, a jumper register 74 is arranged so that an ECLIPSE® ENABLE and/or a microNOVA® ENABLE is provided. The presence or absence thereof is controlled by the presence or absence of a suitable "jumper" connection being reflected by the state of the "jumper" register 74. The following chart summarizes the conditions for identifying the devices involved.

| MicroNOVA® ENABLE | ECLIPSE® ENABLE | System | ECLIPSE® | MicroNOVA® |
|---|---|---|---|---|
| 0 | 0 | Yes | No | No |
| 0 | 1 | E | E | No |
| 1 | 0 | Yes | No | Yes |
| 1 | 1 | E | E | Yes |

In the first condition where neither jumper connection is enabled the only devices identifiable are "system" devices. Where the ECLIPSE® jumper is enabled but the microNOVA® jumper is not, the system generates the ECLIPSE® timing signals (signified as "E") but the interface unit 14 does not determine whether the devices are ECLIPSE® on system devices. Where the microNOVA® jumper is enabled but the ECLIPSE® jumper is not, both microNOVA® and system devices are identifiable. Where both jumpers are enabled, microNOVA® devices can be identified but the system interface unit does not determine whether the devices are ECLIPSE® or system devices (the ECLIPSE® timing signals are generated). Accordingly, the polling technique permits the system I/O interface unit 14 to determine whether a particular I/O device must be communicated with either on the microNOVA® I/O bus or on the one of the other buses. If a microNOVA® device is present on the microNOVA® bus, its presence is indicated by the microNOVA® poll store unit 73 which provides a microNOVA® sensor signal, µNSNSR, to modify the operation of a master control finite state machine 75 so that its next state of operation provides the necessary control signals to control the operation of the microNOVA® finite state machine 73 for microNOVA® operation. Control signals are shown in Fig. 5 for performing the polling process. The low byte shift register 69 is loaded with the device code at the assertion of LOAD POLL COUNTER by the microNOVA® FSM 72, the poll count beginning at a poll count signal PLWC which increments the poll counter. The high byte shift register is loaded with a suitable instruction which can be selected to produce the least effect on the system (e.g., an IOSKP instruction in which data in all registers remain unchanged, etc.) at the assertion of a LOAD INST signal. If a return IOCLK is recieved at pin 71 a μNEXST signal is asserted by the microNOVA® FSM 72 which signal, together with the device code applied to the address latch of the poll store 73, provides the indication of the presence of the particular device involved. When the complete poll count is completed for start-up, for example, a POLDNE signal is asserted by poll counter 68 for supply to the microNOVA® FSM 73.

The PLWR signal is used on "interrupts" by a device when the CPU acknowledges the interrupt request by such device by asserting an interrupt acknowledge signal. At the assertion of a suitable interrupt achnowledge signal the device itself updates the poll store, via the supplying of its device code and the supplying of the PLWR signal by the master control PSM to the poll store.

For a poll store read operation, when an ADREN signal occurs, the poll store is accessed by the device code if an I/O instruction is present. The poll store then provides a μNSNSR signal to the master control FSM if such device is present.

A poll update request signal (μPUR) is supplied form the master control FSM 75 at the 100 Hz rate as determined by a 100 Hz input counter signal.

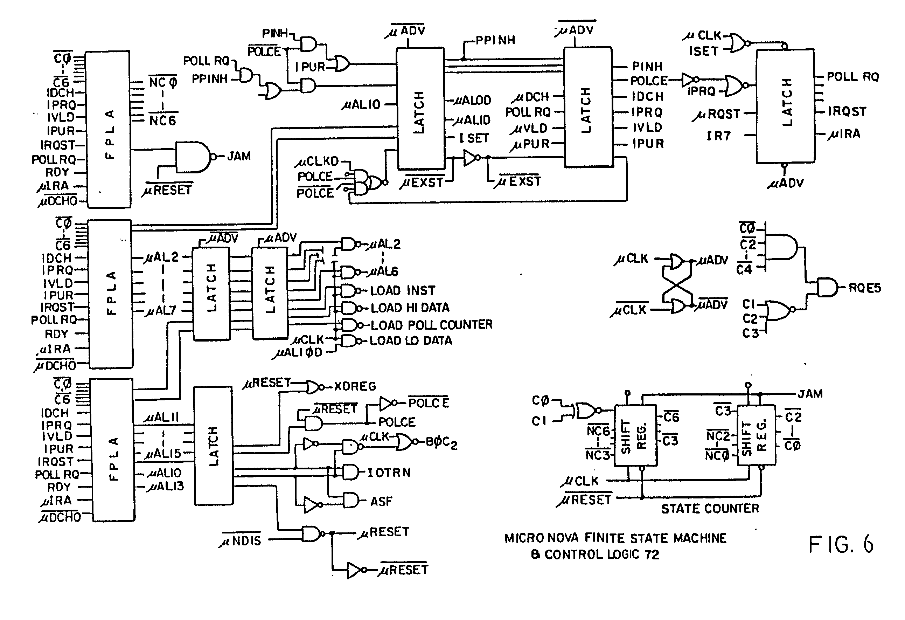

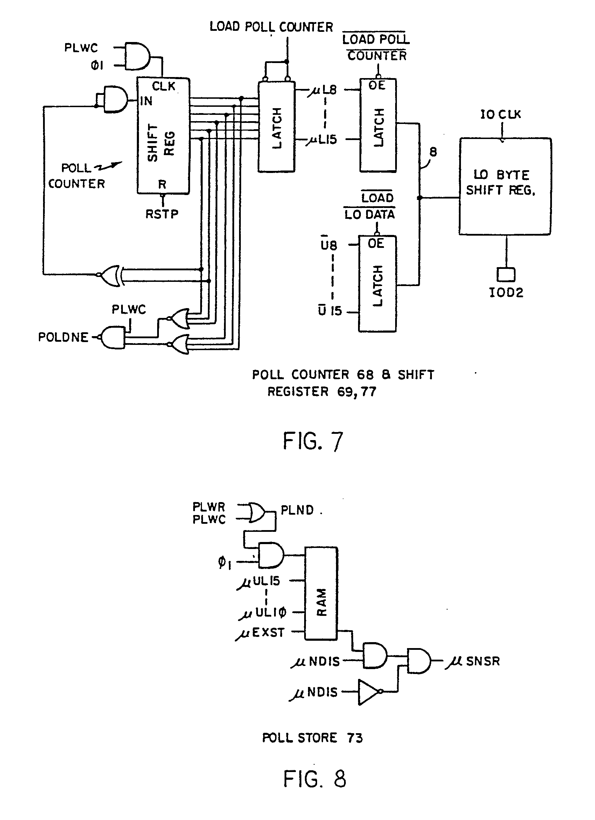

The required microNOVA® instruction register and decode logic 76 and the microNOVA® high byte register 77 for supplying the high byte at microNOVA® bus pin 78 (IODI) are also shown in Figs. 5A and 5B, as well as D-register 79 for shifting data to and from the $\bar{U}$ bus 65 and the microNOVA® shifters 69 and 77, in accordance with standard microNOVA® operation already well known to the art. Specific logic for the microNOVA FSM and control logic unit 72 and the master control FSM and control logic unit 75 are shown in Figs. 5 and 6, respectively. The poll counter 68 and shift registers 69 and 77 are shown in Fig. 7, while the poll store register 73 is shown in Fig. 8.

The system I/O interface unit 14 is designed so as to be capable of operation at more than one input system clock frequency and is, therefore, adaptable for use with a system wherein the system clock is not expected to remain at a single fixed frequency for all operations. The frequency synthesizer unit 51 is provided so as to be responsive to one of a plurality of different selected input frequencies to produce the desired internal clock frequency required for operation of the internal devices of the interface unit and the desired master baud rate signal for operation of the asynchronous terminal system. In a particular embodiment, for example, the internal clock signal must have a substantially constant frequency of 1 MHz so as to provide for correct operation of the internal, or local, devices (such as the PIT and RTC devices mentioned above) and a substatnially constant selected baud rate derived from the substantially constant master baud rate signal for the asynchronous terminal input/output logic.

A full description of the frequency synthesis unit is contained in EP 0 035 334 (and in application No. 83200684=EP 0 097 977 which, like the present application and application 83200686.0=EP 0 094 140 is divided out of 81300560, published as EP 0 035 334).

## Claims

1. A data processing system having a central processor unit (10) and a system bus (11) for providing communication with one or more memory units (12), first and second input/output buses (15A, 15B) providing communication between the system bus (11) and first and second groups respectively of external devices, means (68—71) for polling the devices on an input/output bus to identify each device present on the bus, table means (73) for storing information indicating each device thus identified and means for providing access to devices in accordance with the stored information, characterised in that the system bus (11) communicates with the first and second input/output buses (15A, 15B) through first and second interfaces (14A, 14) respectively, in that the second interface (14) includes a control signal connection to the first interface (14A) and the polling means (68—71) for polling the devices on the second input/output bus (15B), the polling means (68—71) being arranged to effect polling using device code signals for all devices which may be on both input/output buses, thereby to identify each of the external devices of the second group which are currently in communication with the second input/output bus (15B), in that the table (73) stores information which indicates the thus identified external devices present on the second bus, and by means (74) responsive to the stored information for controlling the operation of the second interface (14) to provide access to external devices via the second input/output bus (15B) when such devices are indicated by the table as on the second bus (15B) and to provide access to external devices on the first input/output bus (15A) when such devices are not indicated in the table.

2. A data processing system in accordance with claim 1, characterised in that the polling means (68—71) includes a poll register means (68, 69) for supplying the device code signals, means (72) responsive to information (IOCLK) generated in response to the device code signals by each external device of the second group which is present on the second input/output bus (15B) for producing a signal

## EP 0 164 138 B1

(μNEXIST) which indicates that the external device is so present on the second input/output bus (15B), and in that the table (73) is responsive to the last-named signal and to the coded information for storing information indicating the presence of external devices.

3. A data processing system in accordance with claim 2, characterised in that the table (73) provides a sensing signal (μNSNSR) identifying the presence of an external device on the second input/output bus (15B) and further including bus control means (75) responsive to the sensing signal for providing selected control signals to permit access by the system bus means to the second input/output bus (15B) via the second interface (14).

## Patentansprüche

1. Datenverarbeitungssystem enthaltend: eine Zentraleinheit (10), einen Systembus (11) für die Kommunikation mit einer oder mehreren Speichereinheiten (12), erste und zweite Eingangs-/Ausgangsbusse (15A, 15B) für die Kommunikation zwischen dem Systembus (11) und ersten bzw. zweiten Gruppen von externen Geräten, Mittel (68 bis 71) zum Abrufen der Geräte an einem Eingangs-/Ausgangsbus zur Identifizierung jedes an Bus liegenden Geräts, Tabellenmittel (73) zur Speicherung von Informationen, die jedes so identifizierte Gerät anzeigen, und Mittel zur Herstellung des Zugangs zu den Geräten in Übereinstimmung mit den gespeicherten Informationen, dadurch gekennzeichnet, daß der Systembus (11) durch ein erstes bzw. zweites Interface (14A, 14) mit den ersten und zweiten Eingangs/-Ausgangsbussen (15A, 15B) kommuniziert, daß das zweite Interface (14) eine Steuersignalverbindung zum ersten Interface (14A) und die Abrufmittel (68 bis 71) zum Abrufen der Geräte am zweiten Eingangs-/Ausgangsbus (15B) enthält, wobei die Abrufmittel (68 bis 71) so angeordnet sind, daß sie das Abrufen unter Benutzung von Gerädecodesignalen für alle Geräte durchführen, die an beiden Eingangs-/Ausgangsbussen liegen können, um dadurch jedes der externen Geräte der zweiten Gruppe zu identifizieren, die gerade mit dem zweiten Eingangs-/Ausgangsbus (15B) kommunizieren, daß die Tabelle (73) Informationen speichert, die das so identifizierte, am zweiten Bus vorhandene externe Gerät anzeigen, und daß Mittel (74) vorgesehen sind, die auf die gespeicherte Information unter Steuerung des Betriebs des zweiten Interface (14) ansprechen, um den Zugang zu den externen Geräten über den zweiten Ein-gangs-/Ausgangsbus (15B) herzustellen, wenn diese Geräte von der Tabelle als am zweiten Bus (15B) bufindlich angezeigt werden, und um den Zugang zu externen Geräten am ersten Eingangs-/Ausgangsbus (15A) herzustellen, wenn diese Geräte nicht in der Tabelle angezeigt sind.

2. Datenverarbeitungssystem nach Anspruch 1, dadurch gekennzeichnet, daß die Abrufmittel (68 bis 71) ein Abrufregistremittel (68, 69) zur Lieferung der Gerätecodesignale und Mittel (72) aufweisen, die auf Informationen (IOCLK) ansprechen, die als Antwort auf die Gerätecodesignale von jedem am zweiten Eingangs-/Ausgangsbus (15B) vorhandenen externen Gerät der zweiten Gruppe abgegeben werden, um ein Signal (μNEXIST) zu erzeugen, das anzeigt, daß das externe Gerät am zweiten Eingangs-/Ausgangsbus (15B) vorhanden ist, und daß die Tabelle (73) auf das letztgenannte Signal und auf die codierte Information unter Speicherung einer das Verhandensein der externen Geräte anzeigenden Information anspricht.

3. Datenverarbeitungssystem nach Anspruch 2, dadurch gekennzeichnet, daß die Tabelle (73) ein Abtastsignal (μNSNSR) erzeugt, daß das Verhandensein eines externen Geräts am zweiten Eingangs-/Ausgangsbus (15B) identifiziert, und daß weiter Bussteuermittel (75) vorgesehen sind, die auf der Abtastsignal mit der Erzeugung ausgewählter Steuersignale ansprechen, um durch die Systembusmittel den Zugang zum zweiten Eingangs-/Ausgangsbus (15B) über das zweite interface (14) zu ermöglichen.

## Revendications

1. Un système de traitement de données, comportant une unité centrale de traitement (10) et un bus système (11) permettant d'établir une communication avec une ou plusieurs unités mémoire (12), un premier et un second bus d'entrée/sortie (15A, 15B) permettant d'établir une communication entre le bus système (11) et un premier et un second groupe respectif de dispositifs externes, des moyens (68 à 71) pour scruter les dispositifs se trouvant sur un bus d'entrée/sortie afin d'identifier chaque dispositif se trouvant sur ce bus, des moyens formant table (73) pour mémoriser une information indicatrice de chaque dispositif ainsi identifié, et des moyens pour assurer l'accès à des dispositifs en fonction de cette information mémorisée,

caractérisé en ce que le bus système (11) communique avec le premier et le second bus d'entrée/sortie (15A, 15B) par l'intermédiaire d'une première et d'une seconde interface (14A, 14), respectivement, en ce que la seconde interface (14) comporte une liaison de signal de contrôle à la première interface (14A) et aux moyens de scrutation (68 à 71), qui permet de scruter les dispositifs se trouvant sur le second bus d'entrée/sortie (15B), les moyens de scrutation (68 à 71) étant conçus de manière à réaliser la scrutation au moyen de signaux de code de dispositif pour tous les dispositifs susceptibles de se trouver sur l'un ou l'autre des bus d'entrée/sortie, permettant ainsi d'identifier chacun des dispositifs externes du second groups qui sont effectivement en communication avec le second bus d'entrée/sortie (15B), en ce que le table (73) mémorise des informations qui indiquent les dispositifs externes ainsi identifiés se trouvant sur le second bus, et en ce qu'il est prévu des moyens (74) pour contrôler, en réponse à l'information mémorisée, le fonctionnement de la seconde interface (14) de manière à assurer l'accès à des dispostifs

7

externes via le second bus d'entrée/sortie (15B) lorsque la table indique que des dispositifs se trouvant sur le second bus (15B) et pour permettre l'accés à des dispositifs externes sur le premier bus d'entrée/sortie (15A) lorsque la table n'indique pas la présence de ces dispositifs.

2. Le système de traitement de données de la revendication 1, caractérisé en ce que les moyens de scrutation (68 à 71) comprennent des moyens formant registre de scrutation (68, 69) pouvant délivrer les signaux de code de dispositif, des moyens (72) pour produire, en réponse à une information (IOCLK) elle-même produite, en réponse au signaux de code de dispositif, par chaque dispositif externe du second groupe se trouvant sur le second bus d'entrée/sortie (15B), un signal (µNEXIST) indiquant que le dispositif externe est ainsi présent sur le second bus d'entrée/sortie (15B), et en ce que la table (73) mémorise, en réponse à ce dernier signal et à l'information codée, une information indiquant la présence de dispositifs externes.

3. Le système de traitement de données de la revendication 2, caractérisé en ce que la table (73) délivre un signal de détection (µNSNSR) identifiant la présence d'un dispositif externe sur le second bus d'entrée/sortie (15B), le système comprenant en outre des moyens de contrôle de bus (75) délivrant, en réponse au signal de détection, des signaux de contrôle choisis permettant aux moyens de bus système d'accéder au second bus d'entrée/sortie (15B) via la seconde interface (14).

**EP 0 164 138 B1**

FIG.1

FIG. 2

FIG 3

FIG. 4

FIG. 5

MASTER CONTROL FINITE STATE MACHINE
& CONTROL LOGIC 75

EP 0 164 138 B1

FIG. 6

MICRO NOVA FINITE STATE MACHINE & CONTROL LOGIC 72

POLL COUNTER 68 & SHIFT
REGISTER 69,77

FIG. 7

POLL STORE 73

FIG. 8